# EUROPEAN PATENT APPLICATION

(11) **EP 4 477 710 A1**
(43) Date of publication of application: **18.12.2024**
(21) Application number: 23749760.7
(22) Date of filing: 01.02.2023
(51) Int. Cl.: C08L 35/02, C08F 22/14, C08K 3/36, C09J 4/00, C09J 135/00, C09K 3/10

(54) **RESIN COMPOSITION AND CURABLE RESIN COMPOSITION USING SAME**

(30) Priority: 07.02.2022 JP 2022017009
(71) Applicant: Namics Corporation, Niigata-shi, Niigata 950-3131 (JP)
(72) Inventor: YOSHII Yu, Niigata-shi, Niigata 950-3131 (JP)
(74) Representative: Hoffmann Eitle
(86) International application number: PCT/JP2023/003141
(87) International publication number: WO 2023/149444

(57) **Abstract**

An object of the present invention is to provide a resin composition comprising a 2-methylene-1,3-dicarbonyl compound with improved workability.

The resin composition comprises:
(A) a 2-methylene-1,3-dicarbonyl compound having at least one structural unit represented by formula (I) below: 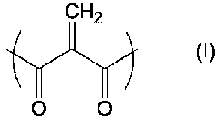 and a molecular weight of 230 ~ 1,000; and
(B) fumed silica having an average primary particle size of 1 nm ~ 50 nm and a specific surface area of 50 m²/g ~ 250 m²/g.

## Description

### TECHNICAL FIELD

The present invention relates to a resin composition, a curable resin composition or a kit comprising the same, a cured product thereof, and electronic parts comprising the cured product.

### BACKGROUND ART

Currently, adhesives, sealing materials, and others comprising curable compositions are often used in the assembly and mounting of electronic components used in semiconductor devices for such purposes as maintaining reliability. Semiconductor devices, for example, electronic devices such as smart phones are composed of various electronic modules. Many of the components constituting these electronic modules contain materials whose mechanical and/or electronic properties and the like are deteriorated by heat. Therefore, it is desirable to assemble these electronic modules and to assemble and seal electronic devices under relatively low temperature conditions, for example, 100 °C or lower. Therefore, the adhesives and sealing materials used in the manufacture of the above-mentioned electronic devices and modules are required to show sufficient curability even under such low temperature conditions (Patent Document 1).

In recent years, in the production of such electronic components, it has been investigated to use, as an adhesive and the like, a curable resin composition comprising a 2-methylene-1,3-dicarbonyl compound, such as a methylene malonate. Patent Document 2 discloses a resin composition comprising one or more 2-methylene-1,3-dicarbonyl compounds, as a resin composition curable at low temperature of 80 degree or lower, preferably room temperature, and comprising only a small amount of components that volatilize during use (application) or curing and that is suitable as a one-part adhesive for use in the manufacture of an image sensor module or an electronic component.

### PRIOR ART DOCUMENTS

### Patent Documents

Patent Document 1: JP 2016-021033A
Patent Document 2: JP 2018-193530A

### SUMMARY OF THE INVENTION

### Problems to be Solved by the Invention

In the manufacture of electronic components as above, particularly high accuracy of positioning may be necessary for the members thereof. In particular, as electronic components become smaller and more highly integrated, the importance of positioning accuracy in the adhesion or sealing of these components is increasing. With respect to a curable resin composition used in such cases, it may be necessary to exhibit a certain level of viscosity (especially as measured at a low shear rate) or higher. Use of such a curable resin composition brings not only suppression of displacement of members during adhesion but also suppression of liquid dripping from the discharge device and contamination of other members (due to bleeding, flow-in and the like), resulting in improvement of workability.

In contrast, many of the currently known 2-methylene-1,3-dicarbonyl compounds, especially methylene malonates, exhibit low viscosities of less than 100 mPa s. This results in relatively low viscosity exhibited by a curable resin composition containing a 2-methylene-1,3-dicarbonyl compound, which may inhibit improvement of workability in the manufacture of electronic components. Therefore, with respect to the curable resin composition containing the 2-methylene-1,3-dicarbonyl compound, appropriate increase of the viscosity thereof may be demanded for further improvement of workability in the manufacture of electronic components.

As an example of another property required for a curable resin composition used in the manufacture of electronic components used in semiconductor devices, there can be mentioned an appropriate pot life. This property is important for the manufacture of electronic components which require particularly high accuracy, because the work such as positioning and alignment of components can be performed during only the pot life. The pot life of the curable resin composition can be evaluated, for example, by the gelation time. As used herein, gelation is a phenomenon in which a resin composition loses fluidity as the molecular weight of a resin component (in the present invention, 2-methylene-1,3-dicarbonyl compound) becomes high through a chemical reaction. The gelation time is the time under the predetermined conditions from the point in time when a curable resin composition is ready to start curing to the point in time when the curable resin composition loses fluidity. On the other hand, as used herein, curing and curing time have definitions different from those of gelation and gelation time (pot life), respectively, the former meaning the phenomenon of solidification by the progress of polymerization to become sufficiently harder and stronger for holding and adhering objects, regardless of whether or not a crosslinked structure is formed, and the latter meaning the time necessary for the former.

However, a 2-methylene-1,3-dicarbonyl compound, such as a methylene malonate, is highly reactive as described above, so that it was difficult to obtain a curable resin composition containing that with a pot life (gelation time) suitable for work. Therefore, in the manufacture of electronic components, a curable resin composition containing a 2-methylene-1,3-dicarbonyl compound could be applied only to limited steps.

As a means for adjusting the pot life (gelation time) of a curable resin composition, it is conceivable that the amount of a stabilizer and/or a polymerization inhibitor to be added is increased. However, if this means is applied to curable resin compositions containing 2-methylene-1,3-dicarbonyl compounds, excessively suppressed occurrence of the polymerization reaction may result in variation in curability.

Thus, an object of the present invention is to provide a resin composition comprising a 2-methylene-1,3-dicarbonyl compound with improved workability.

### Solution to the Problems

As a result of intensive research to solve the above-mentioned problem, the present inventors have arrived at the present invention, based on their finding a pot life (gelation time) and viscosity suitable for work are simultaneously imparted to a resin composition without causing variations in curability by incorporation into the resin composition a 2-methylene-1,3-dicarbonyl compound having a specific molecular weight and fumed silica having a specific average primary particle size and specific surface area.

That is, the present invention includes, but is not limited to, the following inventions.
(1) A resin composition comprising:
   (A) a 2-methylene-1,3-dicarbonyl compound having at least one structural unit represented by formula (I) below: 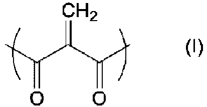 and a molecular weight of 230 ~ 1000; and
   (B) fumed silica having an average primary particle size of 1 nm ~ 50 nm and a specific surface area of 50 m²/g ~ 250 m²/g.
(2) The resin composition according to item (1) above, wherein the content of (B) fumed silica is 0.01 ~ 0.3 part by mass per 1 part by mass of the resin composition.
(3) The resin composition according to item (1) or (2) above, wherein the gelation time of the resin composition (GT), which is a time from the mixing of 0.01 ~ 0.1 part by mass of N,N-dimethylbenzylamine with 1 part by mass of the resin composition at 25 °C until the resin composition loses fluidity, is 1 minute ~ 60 minutes.
(4) The resin composition according to item (3) above, wherein the ratio of the gelation time of the resin composition (GT) relative to the gelation time of the (A) 2-methylene-1,3-dicarbonyl compound (GT_{A}), which is a time from the mixing of 0.01 ~ 0.1 part by mass of N,N-dimethylbenzylamine with 1 part by mass of the (A) 2-methylene-1,3-dicarbonyl compound contained in the resin composition at 25 °C until the (A) 2-methylene-1,3-dicarbonyl compound loses fluidity (wherein the ratio of the mass of N,N-dimethylbenzylamine relative to the mass of the resin composition in the measurement of the GT is equal to the ratio of the mass of N,N-dimethylbenzylamine relative to the mass of the (A) 2-methylene-1,3-dicarbonyl compound in the measurement of the GT_{A}), is 1.1 ~ 3.
(5) The resin composition according to any one of items (1) to (4) above, wherein the viscosity measured using an E-type viscometer at 1 rpm is 100 ~ 100,000 mPa·s.
(6) The resin composition according to any one of items (1) to (5) above, which can be cured by an action of a basic compound as a curing agent or curing catalyst.
(7) The resin composition according to any one of items (1) to (6) above, which further comprises a polymer compound.
(8) The resin composition according to any one of items (1) to (7) above, which contains substantially no Lewis acidic compound capable of coordinating to the carbonyl oxygen of the (A) 2-methylene-1,3-dicarbonyl compound.
(9) The resin composition according to any one of items (1) to (8) above, which is substantially inert to water in the atmosphere.
(10) A one-part curable resin composition comprising the resin composition of any one of items (1) to (9) above and a latentized basic compound or photobase generator.
(11) A kit of a two-part mixing curable resin composition, which comprises:
   (A) the resin composition of any one of items (1) to (9) above, and
   (B) a curing agent or curing catalyst containing a basic compound.
(12) The resin composition according to any one of items (1) to (9) above, the one-part curable resin composition according to item (10) above or the kit according to item (11) above, to be used for the manufacture of electronic components.
(13) A cured product formed by curing the resin composition of any one of items (1) to (9) above, the one-part curable resin composition of item (10) above or the kit of item (11) above.
(14) An electronic component comprising the cured product of item (13) above.

### Effect of the Invention

According to the present invention, it is possible to obtain a resin composition having a pot life (gelation time) and viscosity suitable for work, which comprises a 2-methylene-1,3-dicarbonyl compound, a one-part curable resin composition and a kit of a two-part mixing curable resin composition. The resin composition, a one-part curable resin composition and a kit of a two-part mixing curable resin composition of the present invention are useful for manufacturing various electronic components.

### Description of Embodiments

Embodiments of the prevent invention are described in detail below.

Various numerical ranges are indicated herein using the symbol "~". Each of these numerical ranges includes the numerical values listed immediately before and after the symbol "~" as the lower limit and upper limit, respectively.

The present invention relates to a resin composition. This composition comprises:
(A) a 2-methylene-1,3-dicarbonyl compound having at least one structural unit represented by formula (I) below: 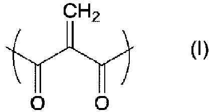 and a molecular weight of 230 ~ 1000; and
(B) fumed silica having an average primary particle size of 1 nm ~ 50 nm and a specific surface area of 50 m²/g ~ 250 m²/g. Components contained in the resin composition of the present invention will be described below.

### (A) 2-Methylene-1,3-dicarbonyl compound

The resin composition of the present invention comprises a (A) 2-methylene-1,3-dicarbonyl compound. In the present invention, the (A) 2-methylene-1,3-dicarbonyl compound is a compound having at least one structural unit represented by formula (I) below: 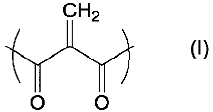 The (A) 2-methylene-1,3-dicarbonyl compound comprises one or two or more structural units of formula (I) above. In some embodiments, the (A) 2-methylene-1,3-dicarbonyl compound comprises two to six, preferably two structural units of formula (I) above.

The structural unit of formula (I) above is composed of a vinyl group with one π-bond carbon having covalently bonded thereto two carbonyl groups and another π-bonded carbon having covalently bonded thereto no substituent. In such a structure, due to the influence of the above-mentioned carbonyl groups, the above-mentioned π-bonded carbon in the above-mentioned vinyl group having covalently bonded thereto no carbonyl group is susceptible to attack by a nucleophile (i.e., the above-mentioned vinyl group is activated). This brings high polymerizability to the (A) 2-methylene-1,3-dicarbonyl compound.

The (A) 2-methylene-1,3-dicarbonyl compound comprises the structural unit of formula (I) above, and these structural units polymerize with each other in the presence of a polymerization initiator, typically a basic compound.

The (A) 2-methylene-1,3-dicarbonyl compound has a molecular weight of 230 ~ 1000, preferably 230 ~ 800, more preferably 240 ~ 800, further preferably 240 ~ 700 particularly preferably 250 ~ 700, and most preferably 250 ~ 550. The molecular weight of the (A) 2-methylene-1,3-dicarbonyl compound, the content by mass of the (A) 2-methylene-1,3-dicarbonyl compound contained relative to the entire curable resin composition of 1 and, when the resin composition contains a plurality of the (A) 2-methylene-1,3-dicarbonyl compounds, the content by mass of each 2-methylene-1,3-dicarbonyl compound relative to the entire (A) 2-methylene-1,3-dicarbonyl compounds in the composition of 1 can be determined, for example, by means of reversed phase high performance liquid chromatography (reversed phase HPLC) using an ODS column as the column and, as the detector, a mass spectrometer (MS) with PDA (detection wavelength: 190 ~ 800 nm) or ELSD. If the molecular weight of the (A) 2-methylene-1,3-dicarbonyl compound is less than 230, the vapor pressure at 25 °C may be excessively high, which may cause various problems arising from volatiles. In particular, volatiles will, on adhering to members in their vicinity, be cured by bases on the surface, leading to contamination of the members in their vicinity. Further, since such (A) 2-methylene-1,3-dicarbonyl compound is highly reactive, it is difficult to ensure the desired gelation time. On the other hand, the (A) 2-methylene-1,3-dicarbonyl compound with a molecular weight exceeding 1,000 results in excessively high viscosity of the composition containing the compound, which decreases workability, and may cause other issues such as imposing limitations on the amount of filler that can be added.

The (A) 2-methylene-1,3-dicarbonyl compound may comprise a multifunctional component. The term multifunctional herein means that the 2-methylene-1,3-dicarbonyl compound comprises two or more structural units of formula (I) above. The number of the structural units of formula (I) above contained in the 2-methylene-1,3-dicarbonyl compound is referred to herein as the "number of functional groups" of the 2-methylene-1,3-dicarbonyl compound. Among the 2-methylene-1,3-dicarbonyl compounds, those for which the number of functional groups is one are referred to as "monofunctional", those for which the number of functional groups is two are referred to as "bifunctional"; and those for which the number of functional groups is three are referred to as "trifunctional." Since a cured product obtained using the (A) 2-methylene-1,3-dicarbonyl compound that comprises a multifunctional component is crosslinked, the cured product has improved physical properties, such as heat resistance and mechanical properties at high temperatures.

When the (A) 2-methylene-1,3-dicarbonyl compound comprises a multifunctional component, a network-like crosslinked structure is formed in the cured product, with the result that the cured product does not flow and maintains a constant storage modulus even at high temperatures, in particular, at temperatures equal to or higher than its glass transition temperature. The storage modulus of the cured product at high temperatures can be measured, for example, by dynamic mechanical analysis (DMA). In general, if a cured product having a crosslinked structure formed therein is evaluated by DMA, a region known as a plateau, the region where changes in storage modulus are relatively small as the temperature changes, is observed over a wide temperature range equal to or higher than its glass transition temperature. The storage modulus in this plateau region is evaluated as a quantity related to crosslink density, i.e., the content of the multifunctional components in the (A) 2-methylene-1,3-dicarbonyl compound.

In an embodiment, the ratio by mass of the (A) 2-methylene-1,3-dicarbonyl compound is preferably 0.05 ~ 0.99, more preferably 0.10 ~ 0.98, further preferably 0.20 ~ 0.97, and particularly preferably 0.50 ~ 0.95, relative to the entire resin composition of the present invention of 1.

In an embodiment, the 2-methylene-1,3-dicarbonyl compound is represented by formula (II) below: 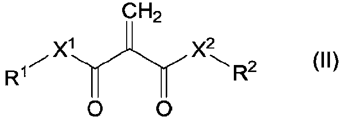 (wherein:
X¹ and X² each independently represent a single bond, O or NR³, wherein R³ represents hydrogen or a monovalent hydrocarbon group,
R¹ and R² are each independently hydrogen, a monovalent hydrocarbon group, or represented by formula (III) below: 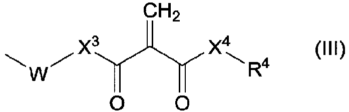 (wherein:
   X³ and X⁴ each independently represent a single bond, O or NR⁵, wherein R⁵ represents hydrogen or a monovalent hydrocarbon group,
   W represents a spacer, and
   R⁴ represents hydrogen or a monovalent hydrocarbon group)).

In an embodiment, the 2-methylene-1,3-dicarbonyl compound is represented by formula (IV) below: 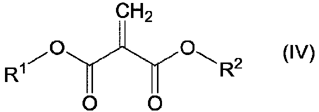 (wherein:
R¹ and R² are each independently hydrogen, a monovalent hydrocarbon group, or represented by formula (V) below: 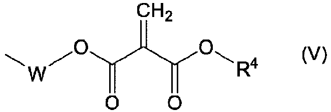 (wherein:
W represents a spacer, and
R⁴ represents hydrogen or a monovalent hydrocarbon group)).

In another embodiment, the 2-methylene-1,3-dicarbonyl compound is a dicarbonylethylene derivative represented by formula (VI) below: 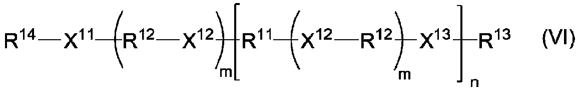 (wherein:
R¹¹ is a 1,1-dicarbonylethylene unit represented by formula (VII) below: 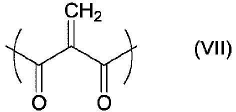
each R¹² each independently represents a spacer,
R¹³ and R¹⁴ each independently represent hydrogen or a monovalent hydrocarbon group,
X¹¹ and each X¹² and X¹³ each independently represent a single bond, O or NR¹⁵, wherein R¹⁵ represents hydrogen or a monovalent hydrocarbon group,
each m each independently represents 0 or 1, and
n represents an integer of 1 ~ 20)).

As used herein, the term monovalent hydrocarbon group refers to a group generated by removing one hydrogen atom from a carbon atom of a hydrocarbon. Examples of the monovalent hydrocarbon group include an alkyl group, an alkenyl group, an alkynyl group, a cycloalkyl group, an alkyl-substituted cycloalkyl group, an aryl group, an aralkyl group, and an alkaryl group, and a portion of each of these groups may contain a heteroatom, such as N, O, S, P and Si. The monovalent hydrocarbon group with a portion thereof may have, for example, a polyether or polyester structure.

Each of the above-mentioned monovalent hydrocarbon groups may be substituted with alkyl, cycloalkyl, heterocyclyl, aryl, heteroaryl, allyl, alkoxy, alkylthio, hydroxyl, nitro, amide, azide, cyano, acyloxy, carboxy, sulfoxy, acryloxy, siloxy, epoxy or ester.

The above-mentioned monovalent hydrocarbon group is preferably an alkyl group, a cycloalkyl group, an aryl group or an alkyl group substituted with a cycloalkyl group, more preferably an alkyl group, a cycloalkyl group or an alkyl group substituted with a cycloalkyl group.

There are no particular restrictions on the carbon number of the alkyl group, alkenyl group, and alkynyl group (hereinafter collectively referred to as the "alkyl group etc."). The carbon number of the alkyl group is typically 1 ~ 18, preferably 1 ~ 16, more preferably 2 ~ 12, even more preferably 3 ~ 10, particularly preferably 4 ~ 8. The carbon number of the alkenyl group and the alkynyl group is typically from 2 ~ 12, preferably from 2 ~ 10, more preferably from 3 ~ 8, even more preferably from 3 ~ 7, and particularly preferably from 3 ~ 6. If the alkyl group etc. have a cyclic structure, the number of carbon atoms in the alkyl group etc. is typically 5 ~ 16, preferably 5 ~ 14, more preferably 6 ~ 12, even more preferably 6 ~ 10. The carbon number of the alkyl group etc. can be identified by, for example, reverse phase HPLC, described above, or nuclear magnetic resonance (NMR).

There are no particular restrictions on the structure of the alkyl group etc. The alkyl group etc. may be linear or may have a side chain. The alkyl group etc. may have a chain structure or a cyclic structure (a cycloalkyl group, a cycloalkenyl group, and a cycloalkynyl group). The alkyl group etc. may have one or more other substituents. For example, the alkyl group etc. may have a substituent comprising an atom other than a carbon atom or a hydrogen atom as a substituent. Also, the alkyl group etc. may comprise one or more atoms other than a carbon atom or a hydrogen atom in a chain structure or a cyclic structure. Examples of the atoms other than a carbon atom or a hydrogen atom above include one or more of an oxygen atom, a nitrogen atom, a sulfur atom, a phosphorus atom, and a silicon atom.

Specific examples of the alkyl group include a methyl group, an ethyl group, an n-propyl group, an i-propyl group, an n-butyl group, an i-butyl group, a sec-butyl group, a t-butyl group, a pentyl group, an isopentyl group, a neopentyl group, a hexyl group, a heptyl group, an octyl group, and a 2-ethylhexyl group. Specific examples of the cycloalkyl group include a cyclopentyl group, a cyclohexyl group, a cycloheptyl group, and a 2-methylcyclohexyl group. Examples of the alkenyl group include a vinyl group, an allyl group, and an isopropenyl group. Specific examples of the cycloalkenyl group include a cyclohexenyl group.

When the 2-methylene-1,3-dicarbonyl compound is represented by formula (II) or (IV) above and R¹ and R² are both monovalent hydrocarbon groups, it is particularly preferable that R¹ and R² are, each, an alkyl group, a cycloalkyl group, an alkyl-substituted cycloalkyl group, an aryl group, an aralkyl group, or an alkaryl groups having 2 ~ 8 carbons.

As used herein, a spacer refers to a divalent hydrocarbon group, more specifically a cyclic, linear or branched, substituted or unsubstituted alkylene group. There are no particular restrictions on the carbon number of the alkylene group. The carbon number of the alkylene group is usually 1 ~ 12, preferably 2 ~ 10, more preferably 3 ~ 8, and still more preferably 4 ~ 8. If desired, the alkylene group may comprise a group comprising a heteroatom selected from N, O, S, P, and Si. The alkylene group may have an unsaturated bond. In an embodiment, the spacer is an unsubstituted alkylene group having 4 ~ 8 carbon atoms. Preferably, the spacer is a linear, substituted or unsubstituted alkylene group, more preferably, an alkylene group having a structure represented by the formula -(CH₂)ₙ-, wherein n is an integer from 2 ~ 10, preferably from 4 ~ 8, and wherein the carbon atoms at both ends are bonded to the remaining moieties of the 2-methylene-1,3-dicarbonyl compound.

Specific examples of the divalent hydrocarbon group for the spacer include, but are not limited to, a 1,4-n-butylene group and a 1,4-cyclohexylene dimethylene group.

If the 2-methylene-1,3-dicarbonyl compound has a spacer, the number of carbon atoms in the terminal monovalent hydrocarbon group is preferably 6 or less. That is, if the 2-methylene-1,3-dicarbonyl compound is represented by formula (II) or (IV) above, it is preferable that R⁴ in formula (III) or (V) above be alkyl having 1 ~ 6 carbon atoms, but if either one of R¹ and R² is represented by formula (III) or formula (V) above, it is preferable that the other of R¹ and R² be alkyl having 1 ~ 6 carbon atoms. In this case, in formula (II) or formula (IV) above, both R¹ and R² may be represented by formula (III) or formula (V) above, and preferably, only either one of R¹ and R² is represented by formula (III) or formula (V) above. Preferably, the 2-methylene-1,3-dicarbonyl compound is represented by formula (IV) above.

Examples of particularly preferable compounds that have a spacer include compounds represented by formula (IV) above, wherein either one of R¹ and R² is any one of an ethyl group, an n-hexyl group or a cyclohexyl group, the other one is represented by formula (V) above, W is either a 1,4-n-butylene group or a 1,4-cyclohexylene dimethylene group, and R⁴ is any one of an ethyl group, an n-hexyl group or a cyclohexyl group. Further, other particularly preferable compounds include compounds represented by formula (IV) above, wherein R¹ and R² are represented by formula (V) above, W is either a 1,4-n-butylene group or a 1,4-cyclohexylene dimethylene group, and R⁴ is any one of an ethyl group, an n-hexyl group or a cyclohexyl group.

A variety of 2-methylene-1,3-dicarbonyl compounds can be synthesized by the methods disclosed in publications of patent applications such as WO2012/054616, WO2012/054633 and WO2016/040261. If both ends of the structural unit represented by formula (I) above contained in the 2-methylene-1,3-dicarbonyl compound are bonded to oxygen atoms, 2-methylene-1,3-dicarbonyl compounds having a higher molecular weight in which a plurality of structural units represented by formula (I) above are linked via an ester bond and the spacer above can be produced by using methods known in the art such as the transesterification with a diol or a polyol disclosed in Japanese Translation of PCT International Application Publication No. JP-T-2015-518503. A 2-methylene-1,3-dicarbonyl compound thus prepared may comprise a hydroxy group in R¹ and R² in formula (II) or formula (IV) above, R⁴ in formula (III) or formula (V) above, and R¹⁴ and R¹³ in formula (VI) above. In particular, a multifunctional component (i.e., the 2-methylene-1,3-dicarbonyl compound having two or more structural units of formula (I) above) can be synthesized by, for example, the method as disclosed in JP 2015-517973A.

Specific examples of preferred compounds as the (A) 2-methylene-1,3-dicarbonyl compound include dipentyl methylene malonate, dihexyl methylene malonate, dicyclohexyl methylene malonate, ethyl octyl methylene malonate, propyl hexyl methylene malonate, 2-ethylhexyl-ethyl methylene malonate, ethylphenyl-ethyl methylene malonate and the like. These are preferable because of their low volatility and high reactivity. From the perspective of handleability, dihexyl methylene malonate and dicyclohexyl methylene malonate are particularly preferable.

As the (A) 2-methylene-1,3-dicarbonyl compound, the above-mentioned 2-methylene-1,3-dicarbonyl compounds can be used individually or in combination.

### (B) Fumed silica

The resin composition of the present invention comprises (B) fumed silica having an average primary particle size of 1 nm ~ 50 nm and a specific surface area of 50 m²/g ~ 250 m²/g. This simultaneously imparts to the resin composition containing the (A) 2-methylene-1,3-dicarbonyl compound a pot life (gelation time) and viscosity suitable for work without causing any variation in curability.

Fumed silica is a particulate, synthetic amorphous silica obtained by the method (dry process) comprising hydrolyzing a halogenated silane, such as silicon tetrachloride, in oxyhydrogen flame. Fumed silica comprises aggregates of primary particles (average primary particle size of about 1 ~ 200 nm) which are fused together by relatively strong interactions. Some of these aggregates are further fused by relatively weak interactions to form agglomerates. The agglomerates are easily deagglomerated by dispersing them in an appropriate medium, but it is difficult to deaggregate the agglomerates to primary particles by ordinary methods.

In the present invention, the average primary particle size of (B) fumed silica is 1 nm ~ 50 nm. In an embodiment, from the viewpoint of obtaining increase in viscosity in a low shear rate range (e.g., 1 rpm) and a pot life (gelation time) suitable for work, the average primary particle size of (B) fumed silica is preferably 1 ~ 40 nm, and more preferably 1 ~ 20 nm. In an embodiment, from the viewpoint of ensuring a longer pot life (gelation time), the average primary particle size of (B) fumed silica is preferably 3 ~ 50 nm, and more preferably 5 ~ 30 nm. In an embodiment, from the viewpoint of shortening the curing time, the average primary particle size of (B) fumed silica is preferably 5 ~ 20 nm, and more preferably 5 ~ 15 nm. As used herein, the gelation time is the time under the predetermined conditions from the point in time when a curable resin composition is ready to start curing to the point in time when the curable resin composition loses fluidity. On the other hand, as used herein, the curing time is the time until solidification by the progress of polymerization to become sufficiently harder and stronger for holding and adhering objects, regardless of whether or not a crosslinked structure is formed. As used herein, the average primary particle size of (B) fumed silica is measured by analyzing, using image processing software, a transmission electron micrograph of a sample of (B) fumed silica taken and quantifying and statistically processing the sizes of all or part of the particles in the micrograph, unless otherwise specified.

In the present invention, the specific surface area of (B) fumed silica is 50 m²/g ~ 250 m²/g. In an embodiment, from the viewpoint of ensuring a longer pot life (gelation time), the specific surface area of (B) fumed silica is preferably 50 m²/g ~ 240 m²/g. In an embodiment, from the viewpoint of shortening the curing time, the specific surface area of (B) fumed silica is preferably 80 ~ 250 m²/g, more preferably 100 ~ 250 m²/g, and further preferably 110 ~ 250 m²/g. As used herein, the specific surface area of (B) fumed silica is measured by the BET method unless otherwise specified.

The surface of (B) fumed silica may be hydrophobized by a surface treatment agent. In the present invention, it is preferred that at least a portion of the surface of (B) fumed silica is hydrophobized by a surface treatment agent.

Examples of the surface treatment agent include silicone oil (e.g., polydimethylsiloxane), silane coupling agents (e.g., n-octyltrialkoxysilane), silylating agents (e.g., hexamethyldisilazane and dimethyldichlorosilane) and the like. The surface treatment agent is preferably any of silicone oils, silane coupling agents and silylating agents, and more preferably any of silicone oils, hexamethyldisilazane and dimethyldichlorosilane.

The surface treatment agents used for hydrophobization may be used individually or in combination. A plurality of fumed silica, each of which has been hydrophobized by a different surface treatment agent, may be used in combination.

The content of the (B) fumed silica in the resin composition of the present invention is not particularly limited. The content of (B) fumed silica per 1 part by mass of the resin composition of the present invention, preferably 0.01 - 0.3 part by mass, more preferably 0.02 ~ 0.24 part by mass, and particularly preferably 0.03 ~ 0.19 part by mass.

In addition to the above-mentioned (A) 2-methylene-1,3-dicarbonyl compound and (B) fumed silica, the resin composition of the present invention may contain the components mentioned below, if desired.

### Inorganic fillers

The resin composition of the present invention may further comprise an inorganic filler other than (B) fumed silica, if desired.

Examples of the inorganic filler include silica produced by a method other than dry method, such as melting method, vaporized metal combustion method (VMC method) and sol-gel methods; metal oxides, such as calcium carbonate, alumina and zinc oxide; metals, such as nickel, copper and silver; glass beads, bentonite, acetylene black, ketjen black and the like. The inorganic filler may be subjected to surface treatment with a silane coupling agent or the like. An inorganic filler that has been subjected to surface treatment is expected to have an effect of preventing agglomeration of the inorganic filler. The inorganic fillers may be used individually or in combination.

The average particle size (if not spherical, the average maximum diameter) of the inorganic filler is not particularly limited but, for ease of dispersing the filler uniformly in the resin composition and for other reasons, such as excellent injectability when the resin composition is used as an adhesive or a liquid sealing material such as an underfill, it is preferred that this is 0.005 ~ 50 µm. The average particle size of the inorganic filler is measured by a laser diffraction scattering particle size distribution meter or a NANOTRACK dynamic light scattering particle size analyzer.

The inorganic filler may be electrically insulative or conductive. When the inorganic filler is electrically insulative, the content of the inorganic filler is preferably 0 ~ 95 parts by mass, more preferably 0 ~ 85 parts by mass, and further preferably 0 ~ 50 parts by mass, relative to 100 parts by mass in total of all the components of the resin composition. In an embodiment, when the resin composition is used as a liquid sealing material, such as underfill, from the viewpoint of possibility of avoiding of deterioration of the injectability of the resin composition, the content of the inorganic filler is preferably 0 ~ 50 parts by mass, relative to 100 parts by mass in total of all the components of the resin composition. In an embodiment, from the viewpoint of possibility of lowering of the linear expansion coefficient of the resin composition, the content of the inorganic filler is preferably 10 - 95 parts by mass, relative to the 100 parts by mass in total of all the components of the resin composition. When the inorganic filler is electrically conductive, in order for the resin composition to be capable of being used as a conductive paste, from the viewpoint of electrical conductivity, the content of the inorganic filler is 50 ~ 95 parts by mass, relative to 100 parts by mass in total of all the components of the resin composition.

### ·Stabilizer

The resin composition of the present invention may further comprise a stabilizer, if desired.

The stabilizer is for enhancing the stability of the resin composition during storage, and is added to suppress the occurrence of unintended polymerization reactions due to radicals or basic components. The 2-methylene-1,3-dicarbonyl compound may generate radicals by itself at a low probability, and these radicals may act as a starting point to trigger an unintended radical polymerization reaction. The 2-methylene-1,3-dicarbonyl compound may also undergo anionic polymerization reactions when very small amounts of basic components are mixed therein. By adding a stabilizer, the occurrence of such unintended polymerization reactions due to radicals or basic components can be suppressed.

Known stabilizers can be used and, for example, strong acids and radical scavengers can be used. Specific examples of stabilizers include trifluoromethanesulfonic acid, maleic acid, methanesulfonic acid, difluoroacetic acid, trichloroacetic acid, phosphoric acid, dichloroacetic acid, N-nitroso-N-phenylhydroxylamine aluminum, triphenylphosphine, 4-methoxyphenol, and hydroquinone. Among these, a preferred stabilizer is at least one selected from maleic acid, methanesulfonic acid, N-nitroso-N-phenylhydroxylamine aluminum and 4-methoxyphenol. Stabilizers known in the art, such as those disclosed in JP 2010-117545A and JP 2008-184514A, can also be used.

The stabilizers may be used individually or in combination.

### ·Surface treatment agent

The resin composition of the present invention may further comprise a surface treatment agent, if desired.

There is no particular limitation with respect to the surface treatment agent, and typically a coupling agent may be used. A coupling agent has two or more different functional groups in the molecule, one of which is a functional group that chemically bonds to an inorganic material and the other is a functional group that chemically bonds to an organic material. The coupling agent contained in the resin composition improves the adhesion of the resin composition to the substrate and other materials.

Examples of coupling agents include, but are not limited to, silane coupling agents, aluminum coupling agents, titanium coupling agents and the like. The coupling agents may be used individually or in combination.

Examples of functional groups possessed by the coupling agent that chemically bond to organic materials include a vinyl group, an epoxy group, a styryl group, a methacrylic group, an acrylic group, an amino group, an isocyanurate group, a ureido group, a mercapto group, a sulfide group, an isocyanate group and the like.

### .Pigment

The resin composition of the present invention may further comprise a pigment, if desired.

The chromaticity of the resin composition of the present invention can be adjusted by incorporation of a pigment. As the pigments which are not particularly limited, for example, carbon black, titanium black such as titanium nitride, black organic pigments, mixed color organic pigments, inorganic pigments and the like can be used. Examples of black organic pigments include perylene black and aniline black. Examples of mixed-color organic pigments include those obtained by mixing at least two pigments selected from red, blue, green, purple, yellow, magenta, cyan and the like to obtain a pseudo-black color. Examples of inorganic pigments include graphite, and fine particles of metals and their oxides, composite oxides, sulfides, nitrides and the like. Examples of these metals include titanium, copper, iron, manganese, cobalt, chromium, nickel, zinc, calcium, silver and the like. Pigments may be used individually or in combination. The pigment is preferably carbon black or titanium black.

### .Plasticizers

The resin composition of the present invention may further comprise a plasticizer, if desired.

As a plasticizer, any known plasticizer can be contained. The plasticizer can improve moldability and/or adjust the glass transition temperature. The plasticizer with good compatibility and low tendency to bleed can be used.

Examples of the plasticizers include phthalates, such as di-n-butyl phthalate, di-n-octyl phthalate, bis(2-ethylhexyl) phthalate, di-n-decyl phthalate and diisodecyl phthalate; adipates, such as bis(2-ethylhexyl) adipates and di-n-octyl adipates; sebacates, such as bis(2-ethylhexyl) sebacate and di-n-butyl sebacate; azelates, such as bis(2-ethylhexyl) azelate; paraffins, such as chlorinated paraffin; glycols, such as polypropylene glycol; epoxy-modified vegetable oils, such as epoxidized soybean oil and epoxidized linseed oil; phosphates, such as trioctyl phosphate and triphenyl phosphate; phosphites, such as triphenylphosphite; ester oligomers, such as esters of adipic acid and 1,3-butylene glycol; low molecular weight polymers, such as low molecular weight polybutene, low molecular weight polyisobutylene and low molecular weight polyisoprene; and oils, such as process oils and naphthenic oils.

The plasticizers may be used individually or in combination.

### Polymer compounds

The resin composition of the present invention may further comprise a polymer compound, if desired. In one embodiment, the resin composition of the present invention further comprises a polymer compound.

The polymer compound is usually used to adjust the viscosity of the resin composition. In the resin composition of the present invention, the polymer compound may be dissolved or dispersed as a particulate solid, and it is preferred that the polymer compound is dissolved.

In the resin composition of the present invention, when the polymer compound is dissolved, the polymer compound preferably has a weight average molecular weight of 10,000 ~ 1,000,000. From the viewpoint of this solubility, the polymer compound is preferably a (meth)acrylate polymer. The term "(meth)acrylate polymer" is a generic term for "acrylate polymer" and "methacrylate polymer". An acrylate polymer is a polymer obtained by polymerizing one or more alkyl acrylates (alkyl esters of acrylic acid), and a methacrylate polymer is a polymer obtained by polymerizing one or more alkyl methacrylates (alkyl esters of methacrylic acid). (Meth)acrylate polymers also include a copolymer obtained by copolymerizing an alkyl acrylate and an alkyl methacrylate.

On the other hand, in the resin composition of the present invention, when the polymer compound is dispersed as a particulate solid, the average primary particle size of the particulate solid is preferably 100 µm or less. Further, the particulate solid may be formed of crystals of the polymer compound or the polymer compound in an amorphous form.

When the resin composition of the present invention further comprises a polymer compound, the content of the polymer compound is preferably 0.1 ~ 20 parts by mass, and more preferably 1 ~ 10 parts by mass per 100 parts by mass of the total of all components of the resin composition.

The resin composition of the present invention may further comprise components other than each of the above components, such as a flame retardant, an ion trapper, an antifoaming agent, a leveling agent, a foam breaker, a solvent and the like, as long as the effect of the invention is not impaired. When the influence on the environment is considered, it is preferred that no organic solvent is contained.

The resin composition of the present invention comprises, in addition to the (A) 2-methylene-1,3-dicarbonyl compound and (B) fumed silica described above, each of the above components, if necessary. The resin composition of the present invention can be prepared by mixing these components. Apparatuses known in the art can be used for mixing. For example, mixing can be performed by apparatuses known in the art, such as a Henschel mixer or a roll mill. These components may be mixed simultaneously, or it may be such that some are mixed first, and the remainder are mixed later.

The resin composition of the present invention may have various physical and/or chemical properties as necessary, taking into consideration workability and the like in the assembly and mounting of electronic components used in semiconductor devices. For example, in one embodiment, in the resin composition of the present invention, the viscosity measured at 1 rpm using an E-type viscometer is preferably 100 ~ 100,000 mPa s, more preferably 200 ~ 80,000 mPa s, further preferably 500 ~ 50,000 mPa s, and particularly preferably 1,000 ~ 10,000 mPa s. When the viscosity of the resin composition (measured at a low shear rate) is within the above range, misalignment during assembly/mounting, liquid dripping from the discharge device, contamination of other members (due to bleeding, flowing and the like) can be prevented and workability is improved.

### Basic compound

When the resin composition of the present invention comprising the above components is brought into contact with a basic compound, the resin composition can be cured by the action of the basic compound as a curing agent or a curing catalyst. Therefore, a curable resin composition can be produced by combining the resin composition of the present invention with a curing agent or curing catalyst containing a basic compound. The basic compound is expected to contribute to the polymerization initiation reaction when the curable resin composition is cured by Michael addition reaction. The basic compounds used in the present invention may be used individually or in combination. In the present invention, also provided is a curable resin composition, especially a one-part curable resin composition, comprising the resin composition of the present invention and one or more basic compounds.

The method of bringing the resin composition of the present invention into contact with the basic compound is not particularly limited. Examples of such methods include a method in which the resin composition of the present invention is mixed with the basic compound, a method in which the resin composition of the present invention is applied on the basic compound pre-applied to the surface of the adherend, a method in which the resin composition of the present invention is applied to the surface of an adherend composed of a solid having basic sites on its surface, and the like.

The basic compound used in the present invention is not particularly limited as long as it is a compound exhibiting sufficient basicity to act as a curing agent or a curing catalyst for the resin composition of the present invention, and typically comprises an organic base, an inorganic base, or an organometallic material.

The organic base includes an amine compound and the like described later.

The inorganic base includes an alkali metal hydroxide, such as lithium hydroxide, sodium hydroxide, potassium hydroxide and cesium hydroxide; an alkaline earth metal hydroxide, such as calcium hydroxide; an alkali or alkaline earth metal carbonate, such as lithium carbonate, potassium carbonate and sodium carbonate; a metal hydrogencarbonate, such as potassium hydrogencarbonate and sodium hydrogencarbonate.

The organometallic material includes an organic alkali metal compound, such as butyllithium, t-butyllithium and phenyllithium, and an organocopper reagent prepared from them; an organic alkaline earth metal compound, such as methylmagnesium bromide, dimethylmagnesium and phenylmagnesium chloride, and an organocopper reagent prepared from them; an alkoxide, such as sodium methoxide and t-butyl methoxide; a carboxylate, such as sodium benzoate; and the like.

When the curable resin composition using the resin composition of the present invention is used for an electronic material, if the composition comprises an inorganic base or an organometallic material, there is concern that this may have unintended impact on electrical characteristics in the electrical or electronic circuit in its vicinity. Therefore, the basic compound used in the present invention is preferably free of an alkali metal, an alkaline earth metal, a transition metal element, or a halogen element. In another embodiment, the basic compound used in the present invention is non-ionic. The basic compounds are broadly classified into ionic and non-ionic compounds, and the basic compound is preferably non-ionic, particularly when the basic compound is mixed with the resin composition of the present invention.

The basic compound used in the present invention is preferably an organic base, more preferably an amine compound. The above-mentioned amine compound is an organic compound having at least one of a primary amino group, a secondary amino group and a tertiary amino group in the molecule, and may have two or more amino groups of different classes in the same molecule at the same time.

Examples of compounds having a primary amino group include, for example, methylamine, ethylamine, propylamine, butylamine, ethylenediamine, propylenediamine, hexamethylenediamine, diethylenetriamine, triethylenetetramine, ethanolamine, propanolamine, cyclohexylamine, isophoronediamine, aniline, toluidine, diaminodiphenylmethane, diaminodiphenylsulfone and the like.

Examples of compounds having a secondary amino group include, for example, dimethylamine, diethylamine, dipropylamine, dibutylamine, dipentylamine, dihexylamine, dimethanolamine, diethanolamine, dipropanolamine, dicyclohexylamine, piperidine, piperidone, diphenylamine, phenylmethylamine, phenylethylamine and the like.

Examples of compounds having a tertiary amino group include, for example, triethylamine, tributylamine, trihexylamine, triallylamine, 3-diethylaminopropylamine, dibutylaminopropylamine, tetramethylethylenediamine, tri-n-octylamine, dimethylaminopropylamine, N,N-dimethylethanolamine, triethanolamine, N,N-diethylethanolamine, N-methyl-N,N-diethanolamine, N,N-dibutylethanolamine, triphenylamine, 4-methyltriphenylamine, 4,4-dimethyltriphenylamine, diphenylethylamine, diphenylbenzylamine, N,N-diphenyl-p-anisidine, 1,1,3,3-tetramethylguanidine, N,N-dicyclohexylmethylamine, 1,4-diazabicyclo[2.2.2]octane, 2,6,10-trimethyl-2,6,10-triazaundecane, 1-benzylpiperidine, N,N-dimethylbenzylamine, N,N-dimethyldodecylamine, N-ethyl-N-methylbenzylamine, N,N-diethylbenzylamine and the like.

The compound having two or more amino groups of different classes in the same molecule at the same time is not particularly limited and include, for example, a guanidine compound, an imidazole compound and the like. Examples of the guanidine compound include, for example, dicyanediamide, methylguanidine, ethylguanidine, propylguanidine, butylguanidine, dimethylguanidine, trimethylguanidine, phenylguanidine, diphenylguanidine, toluylguanidine, 1,1,3,3-tetramethylguanidine and the like. Examples of the imidazole compound include, for example, 2-ethyl-4-methylimidazole, 2-methylimidazole, 2-heptadecylimidazole, 2-phenyl-4,5-dihydroxymethylimidazole, 2-undecylimidazole, 2-phenyl-4-methyl-5-hydroxy-methylimidazole, 2-phenyl-4-benzyl-5-hydroxymethylimidazole, 2,4-diamino-6-(2-methylimidazolyl-(1))-ethyl-S-triazine, 2,4-diamino-6-(2'-methylimidazolyl-(1)')-ethylS-triazine·isocyanuric acid adduct, 2-methylimidazole, 2-phenylimidazole, 2-phenyl-4-methylimidazole, 1-cyanoethyl-2-phenylimidazole, 1-cyanoethyl-2-methylimidazole-trimellitate, 1-cyanoethyl-2-phenylimidazole-trimellitate, N-(2-methylimidazolyl-1-ethyl)-urea, and, N,N'-(2-methylimidazolyl-(1)-ethyl)-adipoyldiamide. However, the imidazole compound above is not limited to these compounds.

From the viewpoint of smooth progress of the curing reaction, the above-mentioned amine compound preferably comprises a secondary or tertiary amino group. When the amino group contained in the amine compound is primary, possibility of suppression of the polymerization reaction by an active hydrogen generated from the amino group increases. The above-mentioned amine compound more preferably contains a tertiary amino group. In other words, the above-mentioned amine compound is more preferably a tertiary amine compound.

The above-mentioned amine compound is preferably free of an alkali metal, an alkaline earth metal, a transition metal element, or a halogen element.

The above-mentioned amine compound preferably does not contain a group with an active hydrogen, such as a hydroxy group and a sulfhydryl group.

In the curable resin composition using the resin composition of the present invention, if the basic compound is in a solid form at the time of curing, the reaction proceeds on the surface of the basic compound, and the reaction does not extend throughout the entire composition, resulting in uneven curing. Therefore, it is preferable that the basic compound is not in a solid state at the time of curing, that is, in a liquid state or soluble in the resin composition.

The molecular weight of the above-mentioned amine compound is preferably 100 ~ 1,000, more preferably 100 ~ 500, and further preferably 110 - 300. If the molecular weight of the amine compound is less than 100, the volatility is high, giving rise to concern that it may affect components in the vicinity and cause the cured product to have variable physical properties. If the molecular weight of the amine compound exceeds 1,000, there are concerns about an increase in the viscosity of the amine compound, decrease in dispersibility of the amine compound in the composition, and the like.

In the present invention, the basic compounds may be used individually or in combination.

Specific examples of preferred amine compounds include, but are not limited to, triethylamine, 1,4-diazabicyclo[2.2.2]octane, 1,1,3,3-tetramethylguanidine, N,N-dimethylbenzylamine, N-ethyl-N-methylbenzylamine, 2,6,10-trimethyl-2,6,10-triazaundecane, N,N-dimethyloctylamine, N,N-dimethyloctadecylamine and N,N-dimethyldodecylamine, N,N-diisopropylethylamine and N,N-dicyclohexylmethylamine, but are not limited to these.

In the present invention, the basic compound may be such that it has been rendered inactivated by separation or latentization and can be activated by any stimulus, such as heat, light, mechanical shear or the like. More specifically, the basic compound may be a latent basic compound such as a microcapsule, or those based on ion dissociation or an inclusion compound, or the like, and may be in a form that generates a base by heat, light, electromagnetic waves, ultrasonic waves, or physical shear.

In one embodiment, the basic compound is a photobase generator. A photobase generator is a compound capable of generating a basic compound by a chemical reaction in which light energy is directly or indirectly involved. The photobase generators may be used individually or in combination. In the present invention, the photobase generator is not particularly limited, and it is preferable that the photobase generator is excited by absorption of ultraviolet light (preferably ultraviolet light at a wavelength of 365 nm) and causes a chemical reaction to generate a basic compound, or causes a chemical reaction by the energy transferred from the photosensitizing agent excited by absorption of ultraviolet light to generate a basic compound. The photobase generator preferably has a structure which in principle generates no outgas. The photobase generator may be ionic or non-ionic.

In one embodiment, the basic compound is activated by heat. In this case, the basic compound either (i) is physically separated from the (A) 2-methylene-1,3-dicarbonyl compound before heating and, when heated, allowed to contact with the (A) 2-methylene-1,3-dicarbonyl compound, or (ii) is latentized and exhibits no basicity (and thus shows no activity as a curing agent or curing catalyst) before heating, but becomes capable of exhibiting basicity upon heating. Such a basic compound is not particularly limited, but it is preferred that the basic compound be activated by heating at 40 ~ 100 °C.

The present invention also provides a curable resin composition, particularly a one-part curable resin composition, comprising the resin composition of the present invention, and a latent basic compound or a photobase generator.

Further, it is also possible to form a combination of the resin composition of the present invention as a base resin with a curing agent or curing catalyst comprising at least one basic compound, the combination to be used as a kit of a two-part mixing curable resin composition (adhesive)). That is, the present invention also relates to a kit of a two-part mixing curable resin composition comprising the above-mentioned (A) resin composition; and (B) a curing agent or curing catalyst containing a basic compound. The kit of the two-part mixing curable resin composition of the present invention can be cured by bringing the above-mentioned base resin into contact with the above-mentioned curing agent.

In the present invention, the amount of the basic compound to be used is preferably 0.01 mol% ~ 30 mol%, more preferably 0.01 mol% ~ 10 mol%, relative to the total amount (100 mol%) of the (A) 2-methylene-1,3-dicarbonyl compound in the resin composition. If the amount of the basic compound is less than 0.01 mol%, it results in inconsistent curing. Conversely, if the amount of the basic compound is greater than 30 mol%, a large amount of the basic compound that does not form chemical bonds with the resin matrix remains in the cured product, causing degradation of physical properties of the cured product, bleeding and the like.

As described above, the resin composition of the present invention is cured by the action of a nucleophile, such as an amine compound. Water can also act as a nucleophilic reagent in some cases, but the nucleophilicity (reactivity with an electrophile) of water is not as high as that of the amine compound. Therefore, the resin composition of the present invention usually does not cure even in contact with water, and can be stored in a state in which it is in contact with air containing water vapor. Such properties of the resin composition of the present invention are due to the fact that the electrophilicity (reactivity with a nucleophile) of the (A) 2-methylene-1,3-dicarbonyl compound is high enough to allow direct reaction with amine compounds, but not high enough to allow direct reaction with water. However, if the resin composition of the present invention is contaminated with a substance that increases the electrophilicity of the (A) 2-methylene-1,3-dicarbonyl compound, it may become impossible to store the resin composition of the present invention in contact with air containing water vapor. Examples of such substances include a Lewis acidic compound. A Lewis acidic compound has an effect of enhancing electrophilicity of the (A) 2-methylene-1,3-dicarbonyl compound by coordinating to the carbonyl oxygen of the (A) 2-methylene-1,3-dicarbonyl compound and withdrawing electrons thereof. Among them, this effect of a Lewis acidic compound containing a mono ~ tetravalent metal cation is particularly high. Therefore, the resin composition of the present invention preferably contains no Lewis acidic compound, particularly a Lewis acidic compound containing a mono ~ tetravalent metal cation.

In one embodiment, the resin composition of the present invention contains substantially no Lewis acidic compound capable of coordinating to the carbonyl oxygen of the (A) 2-methylene-1,3-dicarbonyl compound. In such a case, the resin composition of the present invention is substantially inert to atmospheric water and can be stored in a state in which it is in contact with air containing water vapor.

As an example of properties required for a curable resin composition used in the manufacture of electronic components used in semiconductor devices, there can be mentioned an appropriate pot life. This property is important for the manufacture of electronic components which require particularly high accuracy, because the work such as positioning and alignment of components can be performed during only the pot life. The pot life of the curable resin composition can be evaluated, for example, by the gelation time. As used herein, gelation is a phenomenon in which a resin composition loses fluidity as the molecular weight of a resin component becomes high through a chemical reaction. The gelation time is the time under the predetermined conditions from the point in time when a curable resin composition is ready to start curing to the point in time when the curable resin composition loses fluidity. On the other hand, as used herein, curing and curing time have definitions different from those of gelation and gelation time, respectively, the former meaning the phenomenon of solidification by the progress of polymerization to become sufficiently harder and stronger for holding and adhering objects, regardless of whether or not a crosslinked structure is formed, and the latter meaning the time necessary for the former. The resin composition of the present invention has a pot life (gelation time) suitable for work. As used herein, the gelation time of the resin composition (GT) is the time from the mixing of 0.01 ~ 0.1 part by mass of N,N-dimethylbenzylamine with 1 part by mass of the resin composition at 25°C until the resin composition loses fluidity. The gelation time (GT) for the resin composition of the present invention is preferably 1 minute ~ 60 minutes, more preferably 2 minutes ~ 30 minutes, particularly preferably 3 minutes ~ 15 minutes, and further preferably 4 minutes ~ 10 minutes.

The gelation time of the (A) 2-methylene-1,3-dicarbonyl compound can be measured in substantially the same manner as in the gelation time of the resin composition (GT). That is, as used herein, the gelation time of the (A) 2-methylene-1,3-dicarbonyl compound (GT_{A}) is the time from the mixing of 0.01 ~ 0.1 part by mass of N,N-dimethylbenzylamine with 1 part by mass of the (A) 2-methylene-1,3-dicarbonyl compound contained in the resin composition at 25 °C until the (A) 2-methylene-1,3-dicarbonyl compound loses fluidity.

In the present invention, when the GT_{A} for the (A) 2-methylene-1,3-dicarbonyl compound is compared with the GT for the resin composition of the present invention containing this (A) 2-methylene-1,3-dicarbonyl compound measured under the same conditions, the GT is longer than the GT_{A}. That is, the resin composition of the present invention exhibits an extended gelation time (GT), as compared to the gelation time (GT_{A}) for the (A) 2-methylene-1,3-dicarbonyl compound contained therein.

With respect to the resin composition of the present invention having a certain gelation time (GT), the ratio of the gelation time of the resin composition (GT) relative to the gelation time of the (A) 2-methylene-1,3-dicarbonyl compound (GT_{A}) (wherein the ratio of the mass of N,N-dimethylbenzylamine relative to the mass of the resin composition in the measurement of the GT is equal to the ratio of the mass of N,N-dimethylbenzylamine relative to the mass of the (A) 2-methylene-1,3-dicarbonyl compound in the measurement of the GT_{A}) is preferably 1.1 - 3, more preferably 1.5 - 2.5, and particularly preferably 1.7 - 2.1.

The resin composition of the present invention, as well as the curable resin composition and kit using the resin composition of the present invention, can be used as adhesives or sealing materials. In particular, each of them can be used as a one-part resin composition, or a one-part adhesive or sealing material. Furthermore, each of them can be used as a one-part resin composition in a solventless form, or a one-part adhesive or sealing material in a solventless form. Specifically, the above-mentioned resin composition, the curable resin composition and the kit are suitable as an adhesive or sealing material for manufacturing electronic components. More specifically, the above-mentioned resin composition, the curable resin composition and the kit can be used for adhesion and sealing of components for camera module, and are particularly suitable for adhesion of sensor modules, such as image sensor modules. In the present invention, also provided are electronic components adhered using the above-mentioned resin composition or the curable resin composition or the kit using the resin composition. Furthermore, electronic components sealed using the above-mentioned resin composition, the curable resin composition or the kit are also provided. The above-mentioned resin composition and curable resin composition can be used as both insulating compositions and conductive compositions.

The present invention also provides a cured product obtained by curing, as described above, the resin composition of the present invention or the curable resin composition or the kit using the resin composition of the present invention. An electronic component containing this cured product is also provided.

For supplying the curable resin composition to the surface to be adhered, for example, a jet dispenser, an air dispenser or the like can be used. The above-mentioned curable resin composition can be cured at normal temperature without heating. The above-mentioned curable resin composition can be cured by heating at a temperature of, for example, 25 - 80 °C. The heating temperature is preferably 50 - 80 °C. The heating time is, for example, 0.01 - 4 hours.

### EXAMPLES

Examples and comparative examples of the present invention will be described below, but the present invention is not limited to these. In the following Examples and Comparative Examples, part and % refer to part by mass and % by mass unless otherwise noted.

### [Preparation of resin composition]

The raw materials for the resin composition used in Examples and Comparative Examples are as follows.

### ·(A) 2-Methylene-1,3-dicarbonyl compound

The compounds used as the (A) 2-methylene-1,3-dicarbonyl compound in Examples and Comparative Examples are as follows.
(A-1): Dihexyl methylene malonate (DHMM) (manufactured by Sirrus Inc., Chemilian (registered trademark) L3000 XP)
(A-2): Dicyclohexyl methylene malonate (DCHMM) (manufactured by Sirrus Inc., Chemilian (registered trademark) H4000 XP)

The specific structures of the 2-methylene-1,3-dicarbonyl compounds above are as shown in the chemical formulae in Table 1 below.

### [Table 1]

**Table 1**

| | | |
|---|---|---|
| DHMM | Dihexyl methylene malonate | 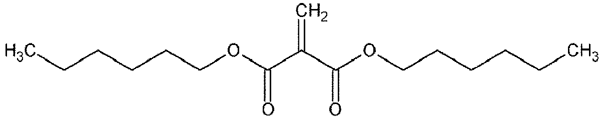 |
| DCHMM | Dicyclohexyl methylene malonate | 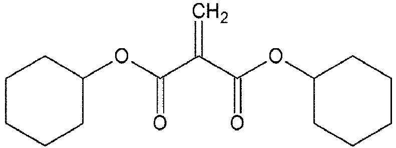 |

### ·(B) Fumed silica

The compounds used as the (B) fumed silica in Examples and Comparative Examples are as follows.
(B-1): Surface-treated fumed silica (trade name: AEROSIL (registered trademark) NX90G, manufactured by Nippon Aerosil Co., Ltd., average primary particle size of 20 nm, a specific surface area of 64 m²/g, surface-treated with hexamethyldisilazane)
(B-2): Surface-treated fumed silica (trade name: AEROSIL (registered trademark) R202, manufactured by Nippon Aerosil Co., Ltd., average primary particle size of 14 nm, a specific surface area of 98 m²/g, surface-treated with a silicone oil)
(B-3): Surface-treated fumed silica (trade name: AEROSIL (registered trademark) R972, manufactured by Nippon Aerosil Co., Ltd., average primary particle size of 16 nm, a specific surface area of 105 m²/g, surface-treated with dimethyldichlorosilane)
(B-4): Surface-treated fumed silica (trade name: AEROSIL (registered trademark) RY200, manufactured by Nippon Aerosil Co., Ltd., average primary particle size of 12 nm, a specific surface area of 107 m²/g, surface-treated with a silicone oil)
(B-5): Surface-treated fumed silica (trade name: CAB-O-SIL (registered trademark) TS-720, manufactured by Cabot Corporation, average primary particle size of 15 nm, a specific surface area of 120 m²/g, surface-treated with a silicone oil)
(B-6): Surface-treated fumed silica (trade name: AEROSIL (registered trademark) RX200, manufactured by Nippon Aerosil Co., Ltd., average primary particle size of 12 nm, a specific surface area of 145 m²/g, surface-treated with hexamethyldisilazane)
(B-7): Non-surface treated fumed silica (trade name: AEROSIL (registered trademark) 200, manufactured by Nippon Aerosil Co., Ltd., average primary particle size of 12 nm, a specific surface area of 207 m²/g, not surface-treated)
(B-8): Surface-treated fumed silica (trade name: AEROSIL (registered trademark) R976S, manufactured by Nippon Aerosil Co., Ltd., average primary particle size of 7 nm, a specific surface area of 238 m²/g, surface-treated with dimethyldichlorosilane)

### ·(B') Fumed silica other than (B) above

(B'-1): Surface-treated fumed silica (trade name: AEROSIL (registered trademark) RX50, manufactured by Nippon Aerosil Co., Ltd., average primary particle size of 40 nm, a specific surface area of 33 m²/g, surface-treated with hexamethyldisilazane)

### ·(C) Basic compound

The compound used as the (C) basic compound used in Examples and Comparative Examples is as follows.
(C-1): N,N-dimethylbenzylamine (manufactured by Tokyo Chemical Industry Co., Ltd., molecular weight: 135.21)

### [Examples 1 ~ 12 and Comparative Examples 1 ~ 3]

The (A) 2-methylene-1,3-dicarbonyl compound and (B) fumed silica (or (B') fumed silica other than (B) above) were mixed in the mass ratios shown in Table 2 by dispersing the latter in the former using a hybrid mixer, to prepare thereby resin compositions. Although Comparative Examples 1 and 2 are a single compound (unless unintentionally mixed impurities are considered), they are referred to here as "resin compositions" for convenience.

In Examples and Comparative Examples, properties of the resin compositions were measured as follows.

### [Evaluation of viscosity of resin composition]

The viscosity (unit: mPa s) of the manufactured resin compositions was measured using an E-type viscometer (TVE-25H: manufactured by Toki Sangyo Co., Ltd., rotor: 3° × R9.7 or 1°34' × R24) set to an appropriate measuring range (H, R or U) under the conditions of 25 °C ± 2 °C and 50% RH ± 10% RH at the rate of rotation of 1 rpm. The results are shown in Table 2. Measured values of less than 640 mPa s are below the calibration limit of the viscometer and given only for reference purpose.

### [Evaluation of gelation time of resin composition]

1 g of the resin composition of each Example and Comparative Example was weighed out and charged into a screw-tube bottle made of borosilicate glass. (C-1) was added to the resin composition (when the resin composition contains DHMM, 0.02 part by mass per 1 part by mass of DHMM, and when the resin composition contains DCHMM, 0.04 part by mass per 1 part by mass of DCHMM) and mixed immediately at normal temperature and, with respect to each resulting mixture, the time until the mixture substantially lost its fluidity with heat generation (the gelation time (GT), unit: minutes) was measured. Further, the ratio of the gelation time of each of the resin compositions of Examples 1 ~ 12 and Comparative Examples 1 ~ 3 (GT) relative to the gelation time of Component (A) (GT_{A}) (that is, the gelation time of the resin composition of Comparative Example 1 or Comparative Example 2) (wherein the ratio of the mass of N,N-dimethylbenzylamine relative to the mass of the resin composition in the measurement of the GT is equal to the ratio of the mass of N,N-dimethylbenzylamine relative to the mass of Component (A) in the measurement of the GT_{A}) was measured. The results are shown in Table 2.

The term "substantially lose its fluidity" means that the contents in the screw-tube bottle becomes so highly viscous that they cannot be stirred with a polypropylene stick.

### [Table 2-1]

**Table 2-1**

| | | Primary particle size (nm) | Specific surface area (m²/g) | Comparative Example 1 | Comparative Example 2 | Comparative Example 3 | Example 1 | Example 2 | Example 3 | Example 4 | Example 5 | Example 6 | Example 7 | Example 8 | Example 9 |
|---|---|---|---|---|---|---|---|---|---|---|---|---|---|---|---|
| Component (A) | (A-1)DHMM | | | 10 | | 9 | 9 | 9 | 9 | 9 | | 9 | 9 | 9 | 9 |
| | (A-2)DCHMM | | | | 10 | | | | | | 9 | | | | |
| Component (B') | (B'-1) | 40 | 33 | | | 1 | | | | | | | | | |
| Component (B) | (B-1) | 20 | 64 | | | | 1 | | | | | | | | |
| | (B-2) | 14 | 98 | | | | | 1 | | | | | | | |
| | (B-3) | 16 | 105 | | | | | | 1 | | | | | | |
| | (B-4) | 12 | 107 | | | | | | | 1 | 1 | | | | |
| | (B-5) | 15 | 120 | | | | | | | | | 1 | | | |
| | (B-6) | 12 | 145 | | | | | | | | | | 1 | | |
| | (B-7) | 12 | 207 | | | | | | | | | | | 1 | |
| | (B-8) | 7 | 238 | | | | | | | | | | | | 1 |
| GT | min | | | 2.5 | 8.0 | 2.5 | 3.5 | 4.0 | 5.0 | 4.0 | 16.0 | 5.0 | 4.5 | 7.0 | 7.0 |
| | times | | | 1.0 | 1.0 | 1.0 | 1.4 | 1.6 | 2.0 | 1.6 | 2.0 | 2.0 | 1.8 | 2.8 | 2.8 |
| Viscosity (1rpm) | mPa.s | | | 11 | 50 | 51 | 1,015 | 4,825 | 520 | 9,040 | 63,800 | 4,430 | 16,200 | 95,000 | 1,200 |

### [Table 2-2]

**Table 2-2**

| | | Primary particle size (nm) | Specific surface area (m²/g) | Example 10 | Example 11 | Example 12 |
|---|---|---|---|---|---|---|
| Component (A) | (A-1)DHMM | | | 9.5 | 9.5 | 9.8 |
| | (A-2)DCHMM | | | | | |
| Component (B') | (B'-1) | 40 | 33 | | | |
| Component (B) | (B-1) | 20 | 64 | | | |
| | (B-2) | 14 | 98 | | | |
| | (B-3) | 16 | 105 | | | |
| | (B-4) | 12 | 107 | 0.5 | | |
| | (B-5) | 15 | 120 | | | |
| | (B-6) | 12 | 145 | | 0.5 | |
| | (B-7) | 12 | 207 | | | 0.2 |
| | (B-8) | 7 | 238 | | | |
| GT | min | | | 3.0 | 3.0 | 4.0 |
| | times | | | 3.0 | 3.0 | 4.0 |
| Viscosity (1rpm) | mPa.s | | | 149 | 65 | 59 |

### (Discussion of results)

The resin composition of the present invention comprising (B) fumed silica having an average primary particle size and specific surface area within a predetermined range in combination with (A) 2-methylene-1,3-dicarbonyl compound had a viscosity (measured at low shear rates) suitable for working (Examples 1 ~ 12), and the gelation time (GT) for the resin composition of the present invention could be moderately prolonged relative to the gelation time (GT_{A}) (Comparative Examples 1 ~ 2) for (A) 2-methylene-1,3-dicarbonyl compound contained in the compositions.

In contrast, the resin composition (Comparative Example 3) comprising fumed silica with an average primary particle size and/or specific surface area not within the predetermined range(s) had very low viscosity, and the gelation time (GT) was not sufficiently extended relative to the gelation time (GT_{A}) (Comparative Examples 1 ~ 2) for (A) 2-methylene-1,3-dicarbonyl compound in the composition.

### Industrial applicability

The resin composition comprising the 2-methylene-1,3-dicarbonyl compound of the present invention is useful in the manufacture of various electronic components because the composition has a pot life (gelation time) and viscosity suitable for work. In particular, the composition is useful in the manufacture of electronic components that require high positional accuracy.

The disclosure of Japanese Patent Application No. 2022-017009 (filing date: February 7, 2022) is incorporated herein by reference in their entirety.

All publications, patent applications, and technical standards mentioned in the present specification are incorporated herein by reference to the same extent as if such individual publication, patent application, and technical standard were specifically and individually indicated to be incorporated by reference.

## Claims

1. A resin composition comprising:
(A) a 2-methylene-1,3-dicarbonyl compound having at least one structural unit represented by formula (I) below: 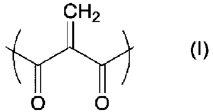 and a molecular weight of 230 ~ 1000; and
(B) fumed silica having an average primary particle size of 1 nm ~ 50 nm and a specific surface area of 50 m²/g ~ 250 m²/g.

2. The resin composition according to claim 1, wherein the content of (B) fumed silica is 0.01 ~ 0.3 part by mass per 1 part by mass of the resin composition.

3. The resin composition according to claim 1 or 2, wherein the gelation time of the resin composition (GT), which is a time from the mixing of 0.01 ~ 0.1 part by mass of N,N-dimethylbenzylamine with 1 part by mass of the resin composition at 25 °C until the resin composition loses fluidity, is 1 minute ~ 60 minutes.

4. The resin composition according to claim 3, wherein the ratio of the gelation time of the resin composition (GT) relative to the gelation time of the (A) 2-methylene-1,3-dicarbonyl compound (GT_{A}), which is a time from the mixing of 0.01 ~ 0.1 part by mass of N,N-dimethylbenzylamine with 1 part by mass of the (A) 2-methylene-1,3-dicarbonyl compound contained in the resin composition at 25 °C until the (A) 2-methylene-1,3-dicarbonyl compound loses fluidity (wherein the ratio of the mass of N,N-dimethylbenzylamine relative to the mass of the resin composition in the measurement of the GT is equal to the ratio of the mass of N,N-dimethylbenzylamine relative to the mass of the (A) 2-methylene-1,3-dicarbonyl compound in the measurement of the GT_{A}), is 1.1 - 3.

5. The resin composition according to any one of claims 1 to 4, wherein the viscosity measured using an E-type viscometer at 1 rpm is 100 - 100,000 mPa s.

6. The resin composition according to any one of claims 1 to 5, which can be cured by an action of a basic compound as a curing agent or curing catalyst.

7. The resin composition according to any one of claims 1 to 6, which further comprises a polymer compound.

8. The resin composition according to any one of claims 1 to 7, which contains substantially no Lewis acidic compound capable of coordinating to the carbonyl oxygen of the (A) 2-methylene-1,3-dicarbonyl compound.

9. The resin composition according to any one of claims 1 to 8, which is substantially inert to water in the atmosphere.

10. A one-part curable resin composition comprising the resin composition of any one of claims 1 to 9 and a latentized basic compound or photobase generator.

11. A kit of a two-part mixing curable resin composition, which comprises:
(A) the resin composition of any one of claims 1 to 9; and
(B) a curing agent or a curing catalyst containing a basic compound.

12. The resin composition according to any one of claims 1 to 9, the one-part curable resin composition according to claim 10 or the kit according to claim 11, to be used for manufacture of electronic components.

13. A cured product formed by curing the resin composition of any one of claims 1 to 9, the one-part curable resin composition of claim 10 or the kit of claim 11.

14. An electronic component comprising the cured product of claim 13.
